# EUROPÄISCHE PATENTANMELDUNG

(11) **EP 3 941 168 A1**
(43) Veröffentlichungstag der Anmeldung: **19.01.2022**
(21) Anmeldenummer: 20185749.7
(22) Anmeldetag: 14.07.2020
(51) Int. Cl.: H05K 5/02, B60R 25/00

(54) **FAHRZEUGMODUL MIT EINER MANIPULATIONSERKENNENDEN ELEKTRONISCHEN STEUEREINHEIT**

(71) Anmelder: ZKW Group GmbH, 3250 Wieselburg (AT)
(72) Erfinder: Jernej, Günther, 8010 Graz (AT); Kieslinger, Dietmar, 2604 Theresienfeld (AT); Schubert, Marion, 1230 Wien (AT); Haiden, Christoph, 2630 Ternitz (AT); Androsch, Bernhard, 7201 Neudörfl (AT); Seibert, Dominic, 2344 Maria Enzersdorf (AT); Sonsky, Jiri, 2700 Wr. Neustadt (AT)
(74) Vertreter: Patentanwaltskanzlei Matschnig & Forsthuber OG

(57) **Zusammenfassung**

Die Erfindung betrifft ein Fahrzeugmodul (10), umfassend eine manipulationserkennende elektronische Steuereinheit (1), wobei die elektronische Steuereinheit (1) dazu eingerichtet ist, zumindest eine elektrisch steuerbare Fahrzeugfunktion, z.B. eine Lichtfunktion, wie eine Abblendlichtfunktion oder einer Fernlichtfunktion, zu steuern.

## Beschreibung

Die Erfindung betrifft ein Fahrzeugmodul.

Weiters betrifft die Erfindung einen Kraftfahrzeugscheinwerfer, umfassend ein erfindungsgemäßes Fahrzeugmodul sowie ein Verfahren zur Verwendung eines erfindungsgemäßen Fahrzeugmoduls.

Zum Schutz vor Wassereintritt, anderen Umwelteinflüssen als auch vor einer Manipulation von außen, umfassen Fahrzeugmodule geschlossene Gehäuse, um die sensible Elektronik der Fahrzeugmodule einzuschließen.

Eine Manipulation der Elektronik kann dabei z.B. durch Öffnen des Gehäuses als auch durch Eindringen von Gegenständen in das Gehäuse erfolgen. Z.B. könnte eine Manipulation erfolgen, indem eine Öffnung in einen Deckel des Gehäuses gebohrt wird, ohne diesen Deckel des Gehäuses abzuheben.

Eine Aufgabe der Erfindung besteht daher darin, ein Fahrzeugmodul zu schaffen, das Manipulationen unterschiedlicher Art zuverlässig erkennt.

Diese Aufgabe wird mit einem Fahrzeugmodul der eingangs genannt Art gelöst, welches erfindungsgemäß eine manipulationserkennende elektronische Steuereinheit umfasst, wobei die elektronische Steuereinheit dazu eingerichtet ist, zumindest eine elektrisch steuerbare Fahrzeugfunktion, z.B. eine Lichtfunktion, wie eine Abblendlichtfunktion oder einer Fernlichtfunktion, zu steuern, wobei die elektronische Steuereinheit folgendes umfasst:
- zumindest einen Schaltungsträger, insbesondere eine Printplatte, umfassend eine elektrische Schaltung zur Durchführung der Steuerung durch die elektronische Steuereinheit,
- ein Gehäuse, das den Schaltungsträger zumindest teilweise einschließt, wobei das Gehäuse zumindest zwei Teile umfasst, wobei an einem ersten Teil des Gehäuses der Schaltungsträger befestigt ist, und wobei ein zweiter Teil des Gehäuses an dem ersten Teil befestigbar ist, um das Gehäuse zumindest teilweise zu verschließen und damit den Schaltungsträger zumindest teilweise einzuschließen, und

- ein auf dem Schaltungsträger angeordnetes Überwachungssystem zur Detektion eines Eindringens in das Gehäuse,
wobei dieses Überwachungssystem folgendes umfasst:
- eine Sendeeinrichtung zur Abgabe eines elektromagnetischen Überwachungssignals in das, durch das Gehäuse eingeschlossene, zu überwachende Volumen, wobei das elektromagnetische Überwachungssignal in einem Wellenlängenbereich zwischen 230 nm und 30m liegt,
- Streumaterial, das in dem zu überwachenden Volumen im nichtmanipulierten Zustand zumindest teilweise zufällig verteilt ist, und dazu eingerichtet ist, das abgegebene elektromagnetische Überwachsungssignal zu streuen,
- eine Empfangseinrichtung zum Empfang des, innerhalb des zu überwachenden Volumens, gestreuten elektromagnetischen Überwachungssignals, wobei die im nichtmanipulierten Zustand zumindest teilweise zufällige Verteilung des Streumaterials so gewählt ist, dass anhand eines Vergleiches des abgegebenen Überwachungssignals mit dem empfangenen, in dem Streumedium gestreuten Signals, ein Wert eines modulindividuellen Fingerabdrucks messbar ist, wobei dieser Wert einen Soll-Wert eines nichtmanipulierten Zustands repräsentiert, und
- eine Manipulationserkennungseinheit, der Informationen zu dem modulindividuellen Fingerabdruck im nichtmanipulierten Zustand, zumindest in Form des Soll-Werts zugeführt sind, wobei die Manipulationserkennungseinheit mit der elektrischen Schaltung verbunden ist, um durch Erfassung des empfangenen Ist-Zustands des Überwachungssignals auf den Ist-Wert des modulindividuellen Fingerabdruckes rückzuschließen, wobei die Manipulationserkennungseinheit dazu eingerichtet ist, den Ist-Wert und Soll-Wert des Fingerabdruckes zu vergleichen und ergebnisabhängig von dem Vergleich, auf eine Manipulation des zu überwachenden Volumens rückzuschließen.

Die Sendeeinrichtung und/oder Empfangseinrichtung kann frei von Elektroden ausgebildet sein. Die zufällige Verteilung des Streumediums kann einerseits durch eine zufällige räumliche Verteilung des Streumediums verursacht werden (also während des händischen oder maschinellen Einbringvorganges des Streumediums). Ergänzend oder alternativ dazu können ebenso innerhalb des Streumediums Streuelemente zufällig angeordnet sein, sodass ein modulindividueller Fingerprint messbar ist. Unter dem Ausdruck "Fingerprint" wird in diesem Kontext natürlich kein menschlicher Fingerabdruck verstanden. Dieser Ausdruck wird vorliegend als Synonym für zumindest einen Messwert verstanden, der modulspezifisch feststellbar ist und von Modul zu Modul naturgemäß variiert. Die Erfindung ermöglicht es durch Erweiterung einer ohnehin bereits vorhandenen elektronischen Steuereinheit eine massive Erhöhung der Manipulationssicherheit eines Fahrzeugmoduls zu erreichen.

Insbesondere kann vorgesehen sein, dass der Wellenlängenbereich des elektromagnetischen Überwachungssignals zwischen 1000 nm und 230 nm liegt. Damit ist eine Überwachung im optischen Wellenlängenbereich möglich. Es kann vorgesehen sein, dass das zu überwachende Volumen zwischen Gehäuse und dem Schaltungsträger mit einem transparenten Medium, das zufällig verteilte Streuzentren aufweist, aufgefüllt ist. Ein Lichtsignal kann z.B. mittels Laser oder LED produziert werden. Durch das dispensierte Medium kann der Lichtweg beeinflusst werden und nur ein gewisser Teil oder auch nur gewisse Frequenzen, des Signals können beim Empfänger (rückwärtsbetriebene LED, Photodiode, Kamera) gemessen werden. Wenn das Gehäuse geöffnet wird, ändert sich die Lichtverteilung, wodurch ein Einbruch detektiert werden kann. Die kostengünstigere Variante läge hier in der Verwendung von LEDs, vor allem SMD-LEDs, da diese mit den derzeitigen Assemblierungsprozessen auf einfache Weise auf der Leiterplatte angebracht werden können. Für die gedachte Anwendung würden hier low-power-LEDs (Nennstrom ca. 2mA) ausreichen. Es kann günstig sein, wenn das verwendete Streumaterial so gewählt ist, dass es im Falle eines Einbruchs mittig durchreißt. Diese Art der Änderung hat einen wesentlich größeren Effekt auf das zu detektierende Signal als dies bei einem Lösen des Streumaterials vom Gehäuse oder dem Schaltungsträger der Fall wäre. Das Streumedium kann insbesondere strategisch günstig an oder in der Nähe von besonders "schützenswerten Bauteilen" platziert sein, oder den gesamten zu überwachenden Innenraum einnehmen. Besonders günstig kann es sein, wenn die Sendeinrichtung und/oder die Empfangseinrichtung in der Nähe der besonders "schützenswerten Bauteile" angebracht wird.

Bei der Verwendung von Lasern oder LED-Lichtquellen kann vorgesehen sein, dass auch mehrere Lichtquellen verwendet werden, die z.B. Licht unterschiedlicher Wellenlänge abstrahlen können. Bei der Verwendung von LEDs im Rückwärtsbetrieb zur Detektion kann vorgesehen sein, dass mit einer Anzahl von N LEDs (wobei N eine natürliche Zahl ist) N*(N-1) optische Pfade gemessen werden. Ein Vorteil bei der Verwendung von rückwärtsbetriebenen LEDs zur Detektion, ist die Möglichkeit der Messung von unterschiedlichen Wellenlängen, da LEDs Licht mit einer Wellenlänge, welche größer ist als ihre eigene, nicht registrieren können. Dies kann vorteilhaft sein, wenn das eingebrachte Medium die Wellenlängen signifikanter ändert als die Lichtpfade, da durch die genannte Methode eine geringere Anzahl von optischen Pfaden, verglichen mit vorab genannten Varianten, gemessen werden kann.

Weiters kann vorgesehen sein, dass das Streumedium transparentes Material umfasst, in dem zufällig verteilte lichtstreuende Streuelemente enthalten sind. Unter dem Ausdruck "lichtstreuend" können sowohl lichtreflektierende und/oder zumindest teilweise absorbierend Eigenschaften verstanden werden. Ebenso sind Brechung (durch den Eintritt in ein Medium mit einem anderen Brechungsindex) und Beugungseffekte relevant. Der Begriff "lichtstreuend" wird daher als abstrakter Begriff verstanden, der jede Art der Manipulation umfassen kann, bei der verändertes Licht abgestrahlt wird. Die Veränderung kann also auch z.B. in der Wellenlänge, Amplitude, Phase, Ausbreitungsrichtung etc. liegen. Diese können z.B. durch Einschlüsse von Luftbläschen oder reflektierenden Granulaten in dem Streumedium realisiert werden. Folgende Materialien können z.B. zur Umsetzung als Streumedium und/oder Streuelement dienen:
- Transparentes, härtendes Gel mit Luftbläschen als Streuzentren: Hier können sogenannte "Optisch klare Silikon-Gele" verwendet werden. Es handelt sich dabei um sehr weiches Gel (Shore OO-OOO), welches durch ein Vermischen zweier Komponenten entsteht. Hier lassen sich Luftbläschen einbringen mit typischen Durchmessern von d= [100µm-2mm]. Ein Vorteil dabei ist, dass kein zusätzliches Granulat benötigt wird.
- Transparentes, härtendes Gel mit Granulat als Streuzentren: In das Gel wird ein Granulat mit abweichender Brechzahl gemischt. (z.B.: Polycarbonatshredder; eventuell auch mit unterschiedlichen Farben. Dies kann bei Verwendung von verschiedenfarbigen LEDs besonders relevant sein). Ein Vorteil hierbei ist, dass diese Variante mechanisch besonders stabil ist.
- Auch eine Variante von Epoxidharz mit Lufteinschlüssen oder ebenfalls reflektierendem Granulat kann hier als kostengünstige Variante verwendet werden. Dieses Harz kann durchsichtig und im ausgehärteten Zustand dennoch ausreichend weich sein, sodass dieses im Falle eines Öffnens des Gehäuses reißen bzw. sich ein Spalt ausbilden kann und sich somit nicht einfach von den Kontaktflächen ablöst.
- Ein Material, welches Fäden zieht: Ein solches Material würde ebenfalls den optischen Weg und somit das detektierte Signal signifikant ändern. In Frage kommen z.B. Variationen von synthetischem Kautschuk oder speziellen Zusammensetzungen basierend auf Harz.
- Auch ist der Einsatz eines Materials denkbar, das beim "Härten" absichtlich viele Schrumpfungsrisse erzeugt.

Insbesondere kann vorgesehen sein, dass das Streumedium dergestalt ausgebildet, angeordnet und mit dem zweiten Teil als auch dem Schaltungsträger verbunden ist, dass im Falle eines Abhebens des zweiten Teils von dem ersten Teil des Gehäuses das Streumedium in zumindest zwei voneinander getrennte Materialbereiche reißt (d.h. ohne dass sich die zwei Materialbereiche von dem zweiten Teil des Gehäuses oder dem Schaltungsträger lösen). Insbesondere kann vorgesehen sein, dass das Material dabei Fäden zieht. Wie erwähnt, würde ein solches Material den optischen Weg und somit das detektierte Signal signifikant ändern.

Weiters kann vorgesehen sein, dass die Sendeeinrichtung zur Abgabe des Überwachungssignals eine LED, insbesondere eine SMD-LED, oder eine Laserlichtquelle umfasst. Die Empfangseinrichtung kann z.B. eine rückwärtsbetriebene LED, eine Photodiode und/oder eine Kamera aufweisen.

Insbesondere kann vorgesehen sein, dass der Wellenlängenbereich des elektromagnetischen Überwachungssignals zwischen 30m und 1m liegt (bezogen auf das Umgebungsmedium Luft). Damit kann die Überwachung in einem Frequenzbereich von 10 MHz bis ca. 300 MHz erfolgen.

Sollte aufgrund von Kriterien, wie z.B. Materialersparnis, eine punktuelle Verteilung des Streumediums gewünscht sein, wäre dies möglich, wenn der Fingerprint z.B. als Ohm'scher Widerstand realisiert ist. Dadurch hätte dieser sein eigenes EM-Feld (bzw. eine zugehörige Verteilung der Feldlinien) und eine Zerstörung seiner Struktur hätte einen signifikanten Einfluss auf den zu messenden Wert.

Als Streumedium bzw. hierfür eingesetztes Material für die Verwendung eines Überwachungssignals in einem Wellenlängenbereich zwischen 30m und 1m kommen z.B. folgende Materialien in Frage:
- Es kann ein Material gewählt werden bei dem εᵣ (relative elektrische Permittivität) und µᵣ (relative magnetische Permittivität) verschieden von Luft ist. Für eine größere Abweichung der EM (elektromagnetischen)-Strahlung bei zerstörtem bzw. intaktem Material ist der Wert µᵣ noch entscheidender als der Wert von εᵣ.
- Eine weitere Möglichkeit besteht in der Verwendung eines Schaums mit zufällig verteilten Ferrit- oder Metallschnipseln.
- Wenn der Fingerprint mittels Ohm'schen Widerstand realisiert werden soll, sind natürlich die leitenden Eigenschaften des Materials von großer Relevanz. Dann sollte ein Material mit deutlich höherer elektrischer Leitfähigkeit als Luft gewählt werden.
- Allgemein gesagt ist jedes Material geeignet, dessen Einfluss auf die EM-Strahlung groß genug ist, um eine Zerstörung messbar zu gestalten.

Weiters kann vorgesehen sein, dass das Streumedium den Schaltungsträger und den zweiten Teil des Gehäuses punktuell kontaktiert (mechanisch sowie gegebenenfalls elektrisch) und miteinander verbindet, wobei das Streumedium zwischen 5% und 95% des zu überwachenden Volumens ausfüllt.

Insbesondere kann vorgesehen sein, dass die von der elektronischen Steuereinheit in einem Sollbetrieb abgebebene Strahlung als Überwachungssignal herangezogen wird und somit die Sendeeinrichtung durch die elektronische Steuereinheit ausgebildet ist, oder die Sendeeinrichtung durch einen von der elektronischen Steuereinheit gesonderten Hochfrequenzmischer ausgebildet ist. Unter dem Ausdruck "Sollbetrieb" wird ein Betriebszustand verstanden, der routinemäßig vorgesehen ist und die Erfüllung einer Sollfunktion der elektronischen Steuereinheit zum Gegenstand hat (beispielsweise der Steuerung einer Lichtfunktion). Die Abstrahlung des Überwachungssignals erfolgt dabei als nützliches Beiprodukt aufgrund des entsprechenden Betriebs der elektronischen Steuereinheit. Der Ausdruck "Sollbetrieb" schließt dabei nicht aus, dass nicht noch andere gewünschte Betriebszustände der elektronischen Steuereinheit vorgesehen sein können. Es handelt sich dabei lediglich um zumindest einen Betriebsmodus, der von einer Vielzahl an unterschiedlichen Sollbetriebsmodi ausgewählt sein kann. Unter dem Ausdruck "Hochfrequenzmischer" wird ein Mischer verstanden, der ein bestimmtes Frequenzband in ein niedrigeres oder höheres Frequenzband überführt. Die Frequenz der Mischung wird durch einen lokalen Oszillator LO bestimmt. In einer besonders vorteilhaften Ausführungsform ist das zu messende Signal die interne elektromagnetische Abstrahlung der ECU (die als Teil der elektronischen Steuereinheit ausgebildet sein kann). Nachteil bei dieser Variante ist, dass hier das gemessene Spektrum genau definiert werden muss, um zu vermeiden, dass es zu einer Störung des gemessenen Signals durch externe EM-Einflüsse kommt. Des Weiteren sollte in dieser Variante auch der Betriebszustand, in dem die Messung durchgeführt wird, genau definiert werden, da der Betrieb von anderen Baugruppen bereits zu einer signifikanten Änderung des gemessenen Signals verursachen kann. Hierbei würde sich empfehlen einen speziellen Frequenzbereich zu betrachten, bei dem die von außen eindringenden Störsignale minimal sind. Auf der ECU-Platine kann dabei eine gedruckte Leitung vorgesehen sein, welche als Empfangsantenne dient. Ein Vorteil dieser Variante ist zum einen, dass kein zusätzlicher Sender von Nöten ist und zum anderen aufgrund der Differenzen im Rahmen der Bauteilherstellung die Individualität bereits durch das von der ECU erzeugte EM-Signal gegeben ist, wodurch eine zusätzliche Individualisierung mittels eines zufälligen Fingerprints die Individualität der jeweiligen elektronischen Einheit vergrößert.

Ebenso kann an diese Antenne ein HF(=Hochfrequenz)-Mischer mit Oszillator angeschlossen werden. Der Ausgang des Mischers soll mittels einem oder zwei Analogeingängen mit der CPU verbunden sein. Das ermöglicht die von der Antenne empfangene Hochfrequenzamplitude und die zugehörige Phase über einen gewissen Frequenzbereich zu ermitteln. Als Signal zur Tamper-Detection kann die Differenzfrequenz zwischen Eingangssignal und LO (=lokaler Oszillator) verwendet werden. Der realistische Messbereich liegt in diesem Fall zwischen 100kH-5GHz. Im Detail kann hier eine Frequenz gewählt werden, welche sich vom restlichen Spektrum sehr signifikant unterscheidet. Dies kann entweder mit einem zusätzlichen Bauteil, oder mit der zusätzlichen Ansteuerung eines bereits vorhandenen Bauteils realisiert werden. In der ersten Variante wird ein Bauteil auf die Leiterplatte aufgebracht, dessen einzige Aufgabe es ist, ein elektromagnetisches Signal zu einem bestimmten Zeitpunkt auszusenden. Alternativ hierzu kann ein spezielles Bauteil mit einem signifikanten EM-Spektrum kurz angesteuert werden. Besonders eignen würde sich hierfür ein bereits auf dem Schaltungsträger vorhandener SBC (System Basis Chip). Für die Messung ist es vorteilhaft, wenn die Transmission zwischen Sender und Empfänger gemessen wird. Dies liegt daran, dass hier das Verhältnis zwischen Sendeamplitude und Empfangsamplitude betrachtet wird, wodurch der erhaltene Wert unabhängig von der Sendeleistung ist.

Weiters kann vorgesehen sein, dass das Streumedium eine Dielektrizitätszahl εᵣ und/oder eine Permeabilitätszahl µᵣ aufweist, die von dem Wert 1 um zumindest 25% abweicht.

Insbesondere kann vorgesehen sein, dass der Wellenlängenbereich des elektromagnetischen Überwachungssignals zwischen 1mm und 30 cm liegt. In diesem Fall kann die Überwachung mittels Radarsignalen erfolgen. Im Streumaterial sollten Streuzentren entsprechend der Wellenlänge des Radars gewählt werden. Dieses Streuzentrum kann z.B. nur an einer Stelle im Raum vorhanden sein. Für diese Variante würden sich besonders Materialen eignen, welche Fäden ziehen, da diese besser vom Radar detektiert werden können. Bei einem "brüchigen" Material, wird das Material so gewählt, dass der Bruch für die Wellenlänge des Radars auch tatsächlich detektierbar ist.

Weiters kann vorgesehen sein, dass die Sendeeinrichtung als Radarchip zur Abgabe eines Radarsignals ausgebildet ist, der auf dem Schaltungsträger angeordnet ist, und insbesondere als Bestandteil der elektronischen Steuereinrichtung ausgebildet ist. Mittlerweile gibt es bereits Radarvarianten, welche den Raum in 2x2 Dimensionen "abrastern" können. Dadurch entsteht ein Bild des gesamten Innenraums der ECU bzw. des gesamten zu überwachendem Volumens. Sollte das Gehäuse oder der Fingerprint deformiert sein, wird diese Änderung durch das Radar erkannt. Der Einbruch wird detektiert. Das bedeutet, dass die Abstrahlung in den Raum mit variablen Winkeln (z.B. in jede Richtung innerhalb des Öffnungswinkels des Radarchips) erfolgen kann, wobei damit ein 2D Bild erfasst werden kann. Dabei kann z.B. durch Laufzeitmessung ein 3D-Bild des überwachten Volumens errechnet werden.

Insbesondere kann vorgesehen sein, dass die Sendeeinrichtung und/oder die Empfangseinrichtung von dem Streumedium überdeckt sind, das sich im Überdeckungsbereich bis hin zu dem zweiten Teil des Gehäuses erstreckt.

Alternativ dazu kann vorgesehen sein, dass sich das Streumedium lückenlos zwischen Sendeeinrichtung und Empfangseinrichtung erstreckt.

Weiters kann vorgesehen sein, dass die Sendeeinrichtung und die Empfangseinrichtung zueinander beabstandet sind und sich zwischen den beiden Einrichtungen das zu überwachende Volumen befindet, wobei der Abstand zwischen den beiden Einrichtungen zumindest 50%, vorzugsweise zumindest 75%, der Länge des Schaltungsträgers beträgt. Unter dem Ausdruck "Länge des Schaltungsträgers" wird die Längserstreckung eines typischerweise weitestgehend rechteckigen ebenen Trägers verstanden. Die Länge ist dabei größer oder zumindest gleich der Breite und erstreckt sich als Gerade zwischen zwei zueinander parallelen Seiten, wobei diese Gerade normal zu den Seiten orientiert ist.

Alternativ dazu kann vorgesehen sein, dass die Sendeeinrichtung und die Empfangseinrichtung an der gleichen Stelle an dem Schaltungsträger angeordnet sind. Dies kann z.B. bei der Verwendung eines Radarchips günstig sein.

Ganz allgemein können zu dem Streumedium folgende Aussagen getroffen werden:
- Ein Material mit hoher Wärmeleitfähigkeit kann zur Verbesserung des thermischen Widerstands Rₜₕ führen
- Eine Verbesserung der mechanischen Verbindung kann durch ein Material erzeugt werden, welches eine hohe Vibrationsabsorption aufweist.
- Weitere Materialien (vermutlich besonders günstig für EM-Variante im Bereich 10MHz bis 300MHz) können auch zur Verbesserung der EMV beitragen. Dabei kann es sich z.B. um Materialien, die elektrisch leitfähige Partikel enthalten, handeln. Dies können z.B. Metallfäden oder Flakes, Graphit Kügelchen oder Flakes, Carbon Nano Tubes oder Graphen-Flakes sein. Möchte man Partikel mit hoher Leitfähigkeit (Metalle) einsetzen, die groß genug sind, dass sie im unbehandelten Zustand Kurzschlüsse am Print verursachen könnten, können zusätzlich entweder die Partikel oder der Print mit einer Isolierschicht (Lack, Oxidschicht etc.) überzogen werden. Auch kommen Ferrit-Partikel oder Partikel mit ferroelektrischen Eigenschaften wie z.B. Barium-Titanat in Betracht.
- Auch wenn das Material nicht komplett raumfüllend dispensiert wird, wird durch die Methode der Messung der gesamte Raum überwacht. Somit wird nicht nur eine Änderung des verwendeten "Fingerprint"-Materials detektiert, sondern auch eine Änderung der Gehäuseform.
- Materialien, die aus der Mischung einer Basis mit zufällig darin verteilten Streuzentren bestehen, können auch raumfüllend verarbeitet werden.

Weiters kann vorgesehen sein, dass das Überwachungssystem dazu eingerichtet ist, den erfassten Ist-Wert des Fingerprints mit dem Soll-Wert zu vergleichen und im Falle von einer Abweichung, die unterhalb eines Grenzwerts liegt, den erfassten Ist-Wert als neuen Soll-Wert abzuspeichern und für den nächsten Vergleich heranzuziehen. Dieser Grenzwert kann so gewählt werden, dass ein Toleranzbereich als Sicherheitspuffer berücksichtigt wird und nicht zu einer fehlerhaften Auslösung führt. Dadurch können Alterungserscheinungen des Fingerprints berücksichtigt werden. Hierfür kann eine Obergrenze für jenen Wert vorgesehen werden, der noch als alterungsbedingte Änderung technisch vorstellbar ist. Diese Obergrenze kann z.B. bei einer Abweichung von 10% des Sollwerts liegen. Überschreitet die Änderung diesen Wert, so kann z.B. von einer Manipulation ausgegangen werden. Auch könnte eine Zeitkomponente berücksichtigt werden, und der Grenzwert für die maximale Änderung aufgrund Alterung, in Abhängigkeit von dem zeitlichen Abstand zur letzten Inbetriebnahme, bestimmt werden. So kann vorgesehen sein, dass bei einem zeitlichen Abstand von nur wenigen Tagen eine Änderung von weniger als 1% zulässig ist, wohingegen bei zeitlichen Abständen von Monaten oder Jahren größere Änderungen zulässig sind. Durch ein einmaliges Messen, z.B. nur während des Startvorganges, kann Energie eingespart werden. Zudem kann beim Erkennen einer Manipulation eine Fehlerroutine eingeleitet werden, die z.B. das Zurücksetzen in einen betriebssicheren vordefinierten Zustand umfasst.

Die Erfindung betrifft weiters einen Kraftfahrzeugscheinwerfer, umfassend ein erfindungsgemäßes Fahrzeugmodul.

Insbesondere betrifft die Erfindung ein Verfahren zur Verwendung eines erfindungsgemäßen Fahrzeugmoduls, wobei während des Herstellungs- und Konfigurationsprozesses des Fahrzeugmoduls eine Grundeinstellungsprozedur durchgeführt wird, in der ein anfänglicher Fingerprint festgestellt und als Referenzwert in dem Fahrzeugmodul und in einem externen Speicher gespeichert wird. Auf diese Weise kann das individuelle Fahrzeugmodul auch noch später aufgrund der Erfassung des individuellen Fingerprints z.B. durch Abgleich mit einer Datenbank eindeutig identifiziert werden. Weiters kann vorgesehen sein, dass der Grenzwert eine zeitliche Komponente aufweist und mit zunehmendem zeitlichem Abstand zur letzten Inbetriebnahme zunimmt.

Die Erfindung ist im Folgenden anhand beispielhafter und nicht einschränkender Ausführungsformen näher erläutert, die in den Figuren veranschaulicht sind. Darin zeigt
Figur 1 eine schematische Darstellung einer ersten Ausführungsform der Erfindung,
Figur 2 eine schematische Darstellung einer zweiten Ausführungsform der Erfindung,
Figur 3a eine schematische Darstellung einer dritten Ausführungsform der Erfindung,
Figur 3b eine beispielhafte Darstellung eines ausgesendeten Überwachungssignals,
Figur 3c eine beispielhafte Darstellung eines empfangenen Überwachungssignals,
Figur 4a eine schematische Darstellung einer vierten Ausführungsform der Erfindung,
Figur 4b eine Detaildarstellung von Feldlinien zu Komponenten der Ausführungsform gemäß Fig. 4a,
Figur 5 eine Draufsicht auf eine weitere Ausführungsform der Erfindung,
Figur 6a bis 6c ein Streumedium im applizierten Zustand vor, während und nach einer Manipulation, und
Figur 7a bis 7c ein Streumedium, das beim Lösen einer mechanischen Verbindung Fäden zieht.

In den folgenden Figuren bezeichnen - sofern nicht anders angegeben - gleiche Bezugszeichen gleiche Merkmale.

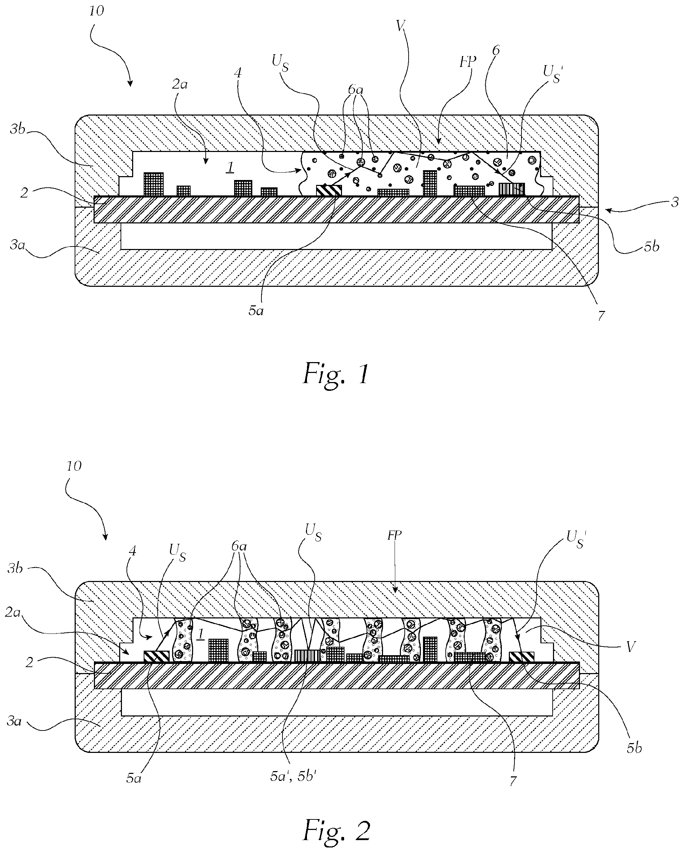

Figur 1 zeigt eine schematische Darstellung einer ersten Ausführungsform der Erfindung. Darin ist ein Fahrzeugmodul 10 gezeigt, das eine manipulationserkennende elektronische Steuereinheit 1 umfasst. Die elektronische Steuereinheit 1 ist dazu eingerichtet zumindest eine elektrisch steuerbare Fahrzeugfunktion, z.B. eine Lichtfunktion, wie eine Abblendlichtfunktion oder einer Fernlichtfunktion, zu steuern, wobei die elektronische Steuereinheit 1 folgendes umfasst: Zumindest einen Schaltungsträger 2, insbesondere eine Printplatte, umfassend eine elektrische Schaltung 2a zur Durchführung der Steuerung durch die elektronische Steuereinheit 1, ein Gehäuse 3, das den Schaltungsträger 2 zumindest teilweise einschließt, wobei das Gehäuse 3 zumindest zwei Teile 3a, 3b umfasst, wobei an einem ersten Teil 3a des Gehäuses 3 der Schaltungsträger 2 befestigt ist, und wobei ein zweiter Teil 3b des Gehäuses 3 an dem ersten Teil 3a befestigbar ist, um das Gehäuse 3 zumindest teilweise zu verschließen und damit den Schaltungsträger 2 zumindest teilweise einzuschließen, und ein auf dem Schaltungsträger 2 angeordnetes Überwachungssystem 4 zur Detektion eines Eindringens in das Gehäuse 3.

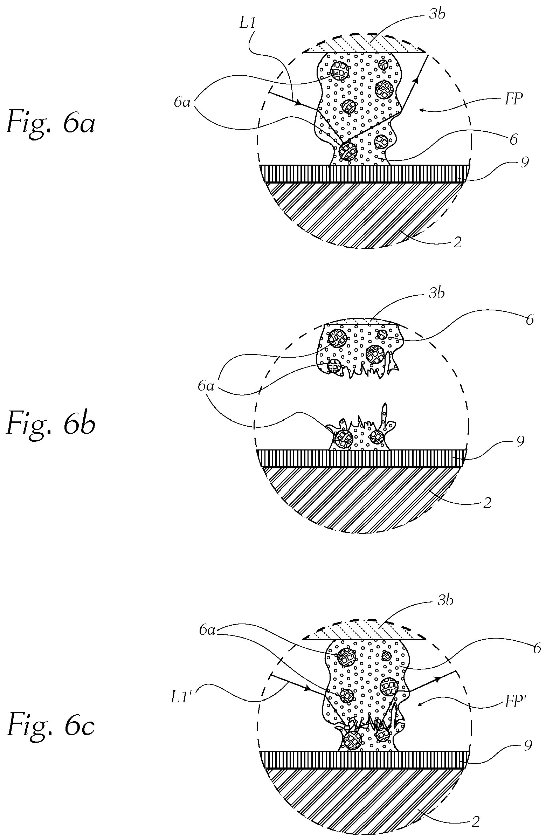

Dieses Überwachungssystem 4 umfasst eine Sendeeinrichtung 5a zur Abgabe eines elektromagnetischen Überwachungssignals Uₛ in das, durch das Gehäuse 3 eingeschlossene, zu überwachende Volumen V, wobei das elektromagnetische Überwachungssignal Uₛ grundsätzlich in einem Wellenlängenbereich zwischen 230 nm und 30m liegt, Streumaterial 6, das in dem zu überwachenden Volumen V im nichtmanipulierten Zustand zumindest teilweise zufällig verteilt ist, und dazu eingerichtet ist, das abgegebene elektromagnetische Überwachsungssignal Uₛ zu streuen, eine Empfangseinrichtung 5b zum Empfang des, innerhalb des zu überwachenden Volumens V, gestreuten elektromagnetischen Überwachungssignals Uₛ, wobei die im nichtmanipulierten Zustand zumindest teilweise zufällige Verteilung des Streumaterials so gewählt ist, dass anhand eines Vergleiches des abgegebenen Überwachungssignals Uₛ mit dem empfangenen, in dem Streumedium gestreuten Signals Uₛ', ein Wert eines modulindividuellen Fingerabdrucks FP messbar ist, wobei dieser Wert einen Soll-Wert Sₛₒₗₗ eines nichtmanipulierten Zustands repräsentiert, und eine Manipulationserkennungseinheit 7, der Informationen zu dem modulindividuellen Fingerabdruck FP im nichtmanipulierten Zustand, zumindest in Form des Soll-Werts zugeführt sind, wobei die Manipulationserkennungseinheit 7 mit der elektrischen Schaltung 2a verbunden ist, um durch Erfassung des empfangenen Ist-Zustands des Überwachungssignals Uₛ auf den Ist-Wert Sᵢₛₜ des modulindividuellen Fingerabdruckes FP rückzuschließen, wobei die Manipulationserkennungseinheit 7 dazu eingerichtet ist, den Ist-Wert Sᵢₛₜ und Soll-Wert Sₛₒₗₗ des Fingerabdruckes FP zu vergleichen (in Figuren 6a bis 7c ist der Sollwert durch den Fingerprint FP repräsentiert, der im nichtmanipulierten Zustand auch dem Ist-Wert entspricht; der Fingerprint FP' wird durch Erkennung des veränderten Ist-Werts erfasst) und ergebnisabhängig von dem Vergleich auf eine Manipulation des zu überwachenden Volumens V rückzuschließen. In den Beispielen gemäß Figuren 1 und 2 handelt sich bei dem Überwachungssignal Uₛ um ein optisches Signal, sodass der Wellenlängenbereich des elektromagnetischen Überwachungssignals Uₛ zwischen 1000 nm und 230 nm liegt. Hierfür kann vorgesehen sein, dass die Sendeeinrichtung 5a zur Abgabe des Überwachungssignals Uₛ eine LED, insbesondere eine SMD-LED, oder eine Laserlichtquelle umfasst. Bei der Empfangseinrichtung 5b kann es sich z.B. um eine rückwärtsbetriebene LED, eine Photodiode oder eine Kamera handeln. Die Sendeeinrichtung 5a und/oder die Empfangseinrichtung 5b sind in dieser Ausführungsform von dem Streumedium 6 überdeckt, das sich im Überdeckungsbereich bis hin zu dem zweiten Gehäuseteil 3b erstreckt.

Das Streumedium 6 umfasst transparentes Material, in dem zufällig verteilte lichtstreuende Streuelemente 6a aufgenommen sind. Das Streumedium 6 ist dergestalt angeordnet, dass es mit dem zweiten Gehäuseteil 3b als auch mit dem Schaltungsträger 2 verbunden ist, sodass im Falle eines Abhebens des zweiten Gehäuseteils 3b von dem ersten Gehäuseteil 3a das Streumedium 6 in zumindest zwei voneinander getrennte Materialbereiche reißt (siehe auch Fig. 6a bis 7c).

Figur 2 zeigt eine schematische Darstellung einer zweiten Ausführungsform der Erfindung. Darin ist das Streumedium 6 nicht in Form einer durchgehenden Füllung angebracht, sondern durch einzelne säulenförmige Verbindungen ausgebildet, die an dem Schaltungsträger 2 und dem Gehäuseteil 3b angreifen. Sendeeinrichtung 5a und Empfangseinrichtung 5b sind dabei an gegenüberliegenden Enden des Schaltungsträgers 2 angeordnet, sodass sämtliche dazwischenliegende Bauteile überwacht werden können, indem all diese Bauteile von einzelnen Bereichen des Streumediums 6 umschlossen sind. Zur Erhöhung der Sensitivität der Überwachung kann auch vorgesehen sein, dass zusätzliche Sendeeinheiten 5a' oder Empfangseinheiten 5b' vorgesehen sind. Die Sendeeinrichtung 5a und/oder die Empfangseinrichtung 5b sind in dieser Ausführungsform von Luft umschlossen und das Streumedium 6 ist zu der Sendeeinrichtung 5a und/oder der Empfangseinrichtung 5b beabstandet. Zwischen den beiden Einrichtungen 5a, 5b befindet sich das zu überwachende Volumen V, wobei der Abstand zwischen den beiden Einrichtungen zumindest 50%, vorzugsweise zumindest 75%, der Länge des Schaltungsträgers 2 beträgt.

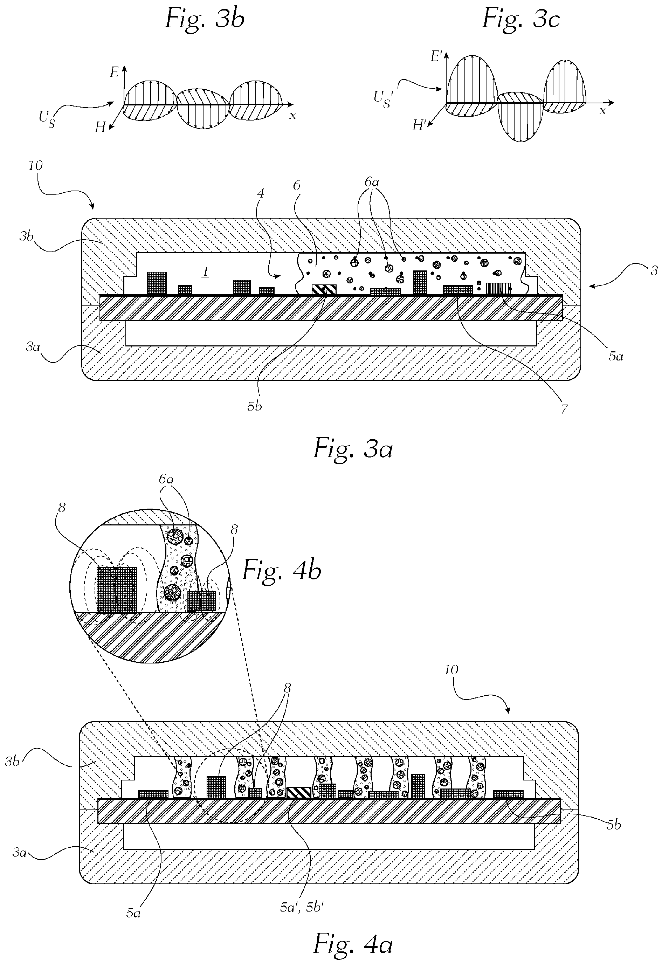

Figur 3a zeigt eine schematische Darstellung einer dritten Ausführungsform der Erfindung, in der beispielsweise die Positionen der Sende- und Empfangseinrichtung 5a bzw. 5b im Vergleich zur ersten Ausführungsform vertauscht sind und das Streumedium 6 bzw. darin enthaltene Streuelemente so gewählt sind, dass sich das abgegebene Überwachsungssignal Us und das empfangene Überwachungssignal Us' z.B. durch das Verhältnis von elektrischer zu magnetischer Feldstärke, voneinander unterscheiden (siehe Fig. 3b und 3c). Dabei zeigt Figur 3b eine beispielhafte Darstellung eines ausgesendeten Überwachungssignals, wobei x die Ausbreitungsrichtung bezeichnet und die magnetische Feldstärke H sowie die elektrische Feldstärke E dargestellt sind, wobei es sich bei diesen Feldstärken um Vektoren handelt. Das Kreuzprodukt aus diesen Vektoren stellt den Pointing Vektor dar, der den Leistungsfluss des elektromagnetischen Signals repräsentiert. In Fig. 3c ist erkennbar, dass bei dem empfangenen Überwachungssignal Us' die magnetische Feldstärke abgenommen und die elektrische Feldstärke zugenommen hat. Natürlich kann das Streumedium 6 bzw. können die Streuelemente 6a auch so gewählt werden, dass die elektrische Feldstärke abnimmt, und die magnetische Feldstärke zunimmt. Auch kann der Leistungsfluss in Summe, durch Absorption oder Reflektion entlang der Ausbreitungsstrecke, reduziert werden. All diese Informationen können durch Vergleich von abgegebenen Signal Us und empfangenen Signal Us' erfasst werden, wodurch sich ein modulindividueller Fingerprint FP berechnen lässt. Auch kann das Streumedium 6 so gewählt sein, dass diese Auswirkung auf die Frequenz bzw. die Frequenzverteilung des empfangenen Signals Us' aufweist. Durch Verwendung eines Frequenzmischers kann die Sensibilität der Manipulationserkennungsvorrichtung zusätzlich erhöht werden, indem sensible Frequenzbereiche, insbesondere Referenzfrequenzen, gezielt analysiert werden.

Figur 4a zeigt eine schematische Darstellung einer vierten Ausführungsform der Erfindung, in der im Gegensatz zu den Varianten gemäß Fig. 1 bis 2 keine optischen Lichtstrahlen, sondern elektromagnetische Signale in einem Frequenzbereich zwischen 10 MHz und 300 MHz abgestrahlt werden. Fig. 4b zeigt dabei die Verteilung von Feldlinien um zu überwachende Bauteile 8 in Form strichlierter elliptischer Linien. Zur besseren Übersicht wurde auf das Einfügen einer Mehrzahl der Bezugszeichen verzichtet. Sämtliche Komponenten können, abgesehen von dem anderen Frequenzbereich des Überwachungssignals U_{S}, analog zu der Variante gemäß Fig. 2 ausgebildet sein.

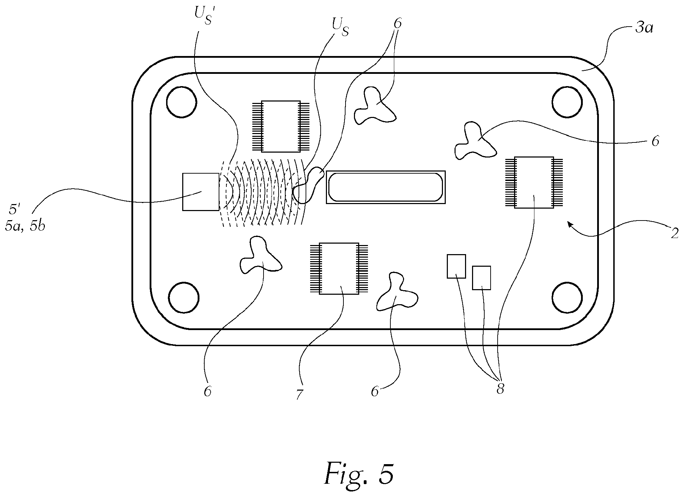

Figur 5 zeigt eine Draufsicht auf eine weitere Ausführungsform der Erfindung, in der eine beispielhafte räumliche Verteilung des Streumediums 6 entlang der zweidimensionalen Ebene des Schaltungsträgers 2 erkennbar ist. Dabei kann vorgesehen sein, dass es sich bei dem abgegebenen Überwachungssignal Us sowie dem empfangenem, vorliegend reflektierten Überwachungssignal Us' um ein Radarsignal handelt. Die Sendeeinrichtung 5a und die Empfangseinrichtung 5b können z.B. einstückig in Form eines einzigen Radarchips 5' ausgebildet sein. Der Radarchip 5' ist dabei auf dem Schaltungsträger 2 angeordnet, und insbesondere als Bestandteil der elektronischen Steuereinrichtung 1 ausgebildet.

Figur 6a bis 6c zeigen ein Streumedium 6 im applizierten Zustand, und zwar vor (Fig. 6a), während (Fig. 6b) und nach einer Manipulation (Fig. 6c). Dabei ist erkennbar, wie das Streumedium 6 bei einem Abheben des Deckels 3b reißt. Auch ein erneutes Montieren des Deckels 3b bzw. ein Zurückführen in seine ursprüngliche Position (siehe Fig. 6c) bleibt weiterhin aufgrund der Veränderung des Streumediums 6 erkennbar, wodurch ein damit assoziierter Fingerprint FP verändert wurde (nämlich hin zu dem manipulierten Fingerprint FP'), wobei diese Veränderung wie bereits ausführlich beschrieben detektiert werden kann und zur Feststellung der Manipulation herangezogen wird. Dieser Veränderung des Fingerprints ist auch an der Änderung eines beispielhaften Strahlengangs L1 (Fig. 6a) hin zu L1' (Fig. 6c) erkennbar.

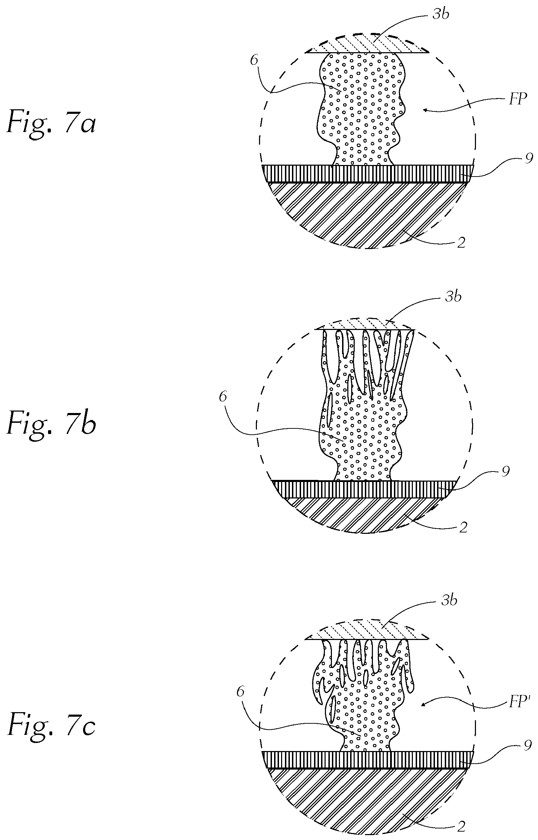

Figur 7a bis 7c zeigen ein Streumedium 6, das beim Lösen einer mechanischen Verbindung Fäden zieht. Wie bereits erwähnt kann ein solches Material bei einer Manipulation den optischen Weg des Überwachungssignals Us und somit das detektierte Signal Us' signifikant ändern. Fig. 7a zeigt zudem, dass eine Lötstopplackschicht 9 auf der Oberfläche des Schaltungsträgers 2 ausgebildet sein kann.

Die Erfindung betrifft weiters einen in den Figuren nicht dargestellten Kraftfahrzeugscheinwerfer, umfassend ein erfindungsgemäßes Fahrzeugmodul 10 sowie ein Verfahren zur Verwendung eines erfindungsgemäßen Fahrzeugmoduls 10, wobei während des Herstellungs- und Konfigurationsprozesses des Fahrzeugmoduls 10 eine Grundeinstellungsprozedur durchgeführt wird, in der ein anfänglicher Fingerprint FP festgestellt und als Referenzwert in dem Fahrzeugmodul und einem externen Speicher gespeichert wird.

Die Erfindung ist nicht auf die gezeigten Ausführungsformen beschränkt, sondern durch den gesamten Schutzumfang der Ansprüche definiert. Auch können einzelne Aspekte der Erfindung bzw. der Ausführungsformen aufgegriffen und miteinander kombiniert werden. Etwaige Bezugszeichen in den Ansprüchen sind beispielhaft und dienen nur der einfacheren Lesbarkeit der Ansprüche, ohne diese einzuschränken.

## Patentansprüche

1. Fahrzeugmodul (10), umfassend eine manipulationserkennende elektronische Steuereinheit (1), wobei die elektronische Steuereinheit (1) dazu eingerichtet ist, zumindest eine elektrisch steuerbare Fahrzeugfunktion, z.B. eine Lichtfunktion, wie eine Abblendlichtfunktion oder einer Fernlichtfunktion, zu steuern, wobei die elektronische Steuereinheit (1) folgendes umfasst:
- zumindest einen Schaltungsträger (2), insbesondere eine Printplatte, umfassend eine elektrische Schaltung (2a) zur Durchführung der Steuerung durch die elektronische Steuereinheit (1),
- ein Gehäuse (3), das den Schaltungsträger (2) zumindest teilweise einschließt, wobei das Gehäuse (3) zumindest zwei Teile (3a, 3b) umfasst, wobei an einem ersten Teil (3a) des Gehäuses (3) der Schaltungsträger (2) befestigt ist, und wobei ein zweiter Teil (3b) des Gehäuses (3) an dem ersten Teil (3a) befestigbar ist, um das Gehäuse (3) zumindest teilweise zu verschließen und damit den Schaltungsträger (2) zumindest teilweise einzuschließen, und
- ein auf dem Schaltungsträger (2) angeordnetes Überwachungssystem (4) zur Detektion eines Eindringens in das Gehäuse (3),
wobei dieses Überwachungssystem (4) folgendes umfasst:
- eine Sendeeinrichtung (5a) zur Abgabe eines elektromagnetischen Überwachungssignals (Uₛ) in das, durch das Gehäuse (3) eingeschlossene, zu überwachende Volumen (V), wobei das elektromagnetische Überwachungssignal (Uₛ) in einem Wellenlängenbereich zwischen 230 nm und 30m liegt,
- Streumaterial (6), das in dem zu überwachenden Volumen (V) im nichtmanipulierten Zustand zumindest teilweise zufällig verteilt ist, und dazu eingerichtet ist, das abgegebene elektromagnetische Überwachsungssignal zu streuen,
- eine Empfangseinrichtung (5b) zum Empfang des, innerhalb des zu überwachenden Volumens (V), gestreuten elektromagnetischen Überwachungssignals (Uₛ), wobei die im nichtmanipulierten Zustand zumindest teilweise zufällige Verteilung des Streumaterials so gewählt ist, dass anhand eines Vergleiches des abgegebenen Überwachungssignals (Uₛ) mit dem empfangenen, in dem Streumedium gestreuten Signals, ein Wert eines modulindividuellen Fingerabdrucks (FP) messbar ist, wobei dieser Wert einen Soll-Wert (Sₛₒₗₗ) eines nichtmanipulierten Zustands repräsentiert, und
- eine Manipulationserkennungseinheit (7), der Informationen zu dem modulindividuellen Fingerabdruck (FP) im nichtmanipulierten Zustand, zumindest in Form des Soll-Werts zugeführt sind, wobei die Manipulationserkennungseinheit (7) mit der elektrischen Schaltung (2a) verbunden ist, um durch Erfassung des empfangenen Ist-Zustands des Überwachungssignals (Uₛ) auf den Ist-Wert (Sᵢₛₜ) des modulindividuellen Fingerabdruckes (FP) rückzuschließen, wobei die Manipulationserkennungseinheit (7) dazu eingerichtet ist, den Ist-Wert (Sist) und Soll-Wert (Sₛₒₗₗ) des Fingerabdruckes (FP) zu vergleichen und ergebnisabhängig von dem Vergleich auf eine Manipulation des zu überwachenden Volumens (V) rückzuschließen.

2. Fahrzeugmodul (10) nach Anspruch 1, wobei der Wellenlängenbereich des elektromagnetischen Überwachungssignals (Uₛ) zwischen 1000 nm und 230 nm liegt.

3. Fahrzeugmodul (10) nach Anspruch 2, wobei das Streumedium (6) transparentes Material umfasst, in dem zufällig verteilte lichtstreuende Streuelemente (6a) aufgenommen sind.

4. Fahrzeugmodul (10) nach Anspruch 2 oder 3, wobei das Streumedium (6) dergestalt ausgebildet, angeordnet und mit dem zweiten Gehäuseteil (3b) als auch dem Schaltungsträger (2) verbunden ist, dass im Falle eines Abhebens des zweiten Teils (3b) von dem ersten Teil (3a) das Streumedium (6) in zumindest zwei voneinander getrennte Materialbereiche reißt.

5. Fahrzeugmodul (10) nach einem der Ansprüche 2 bis 4, wobei die Sendeeinrichtung (5a) zur Abgabe des Überwachungssignals (Uₛ) eine LED, insbesondere eine SMD-LED, oder eine Laserlichtquelle umfasst.

6. Fahrzeugmodul (10) nach Anspruch 1, wobei der Wellenlängenbereich des elektromagnetischen Überwachungssignals (Uₛ) zwischen 30m und 1m liegt.

7. Fahrzeugmodul (10) nach Anspruch 6, wobei das Streumedium (6) den Schaltungsträger (2) und den zweiten Teil (2b) punktuell kontaktiert und miteinander verbindet, wobei das Streumedium (6) zwischen 5 und 95% des zu überwachenden Volumens (V) ausfüllt.

8. Fahrzeugmodul (10) nach Anspruch 6 oder 7, wobei die von der elektronischen Steuereinheit (6) in einem Sollbetrieb abgegebene Strahlung als Überwachungssignal (Uₛ) herangezogen wird und somit die Sendeeinrichtung (5a) durch die elektronische Steuereinheit (6) ausgebildet ist, oder die Sendeeinrichtung (5a) durch einen von der elektronischen Steuereinheit (6) gesonderten Hochfrequenzmischer ausgebildet ist.

9. Fahrzeugmodul (10) nach einem der Ansprüche 6 bis 8, wobei das Streumedium eine Dielektrizitätszahl εᵣ und/oder eine Permeabilitätszahl µᵣ aufweist, die von dem Wert 1 um zumindest 25% abweicht.

10. Fahrzeugmodul (10) nach Anspruch 1, wobei der Wellenlängenbereich des elektromagnetischen Überwachungssignals (Uₛ) zwischen 1mm und 30 cm liegt.

11. Fahrzeugmodul (10) nach Anspruch 10, wobei die Sendeeinrichtung (5a) als Radarchip (5') zur Abgabe eines Radarsignals ausgebildet ist, der auf dem Schaltungsträger (2) angeordnet ist, und insbesondere als Bestandteil der elektronischen Steuereinrichtung (1) ausgebildet ist.

12. Fahrzeugmodul (10) nach einem der vorhergehenden Ansprüche, wobei die Sendeeinrichtung (5a) und/oder die Empfangseinrichtung (5b) von dem Streumedium (6) überdeckt sind, das sich im Überdeckungsbereich bis hin zu dem zweiten Teil (3b) erstreckt.

13. Fahrzeugmodul (10) nach einem der Ansprüche 1 bis 11, die Sendeeinrichtung (5a) und/oder die Empfangseinrichtung (5b) von Luft umschlossen sind und das Streumedium (6) zu der Sendeeinrichtung (5a) und/oder der Empfangseinrichtung (5b) beabstandet ist.

14. Fahrzeugmodul (10) nach einem der vorhergehenden Ansprüche, wobei die Sendeeinrichtung (5a) und die Empfangseinrichtung (5b) zueinander beabstandet sind und sich zwischen den beiden Einrichtungen (5a, 5b) das zu überwachende Volumen (V) befindet, wobei der Abstand zwischen den beiden Einrichtungen zumindest 50%, vorzugsweise zumindest 75%, der Länge des Schaltungsträgers beträgt.

15. Fahrzeugmodul (10) nach einem der vorhergehenden Ansprüche, wobei das Überwachungssystem (4) dazu eingerichtet ist, den erfassten Ist-Wert (Sᵢₛₜ) des Fingerprints (FP) mit dem Soll-Wert (Sₛₒₗₗ) zu vergleichen und im Falle von einer Abweichung, die unterhalb eines Grenzwertes liegt, den erfasst Ist-Wert (Sᵢₛₜ) als neuen Soll-Wert (Sₛₒₗₗ) abzuspeichern und für den nächsten Vergleich heranzuziehen.

16. Fahrzeugmodul (10) nach einem der vorhergehenden Ansprüche, wobei das Überwachungssystem (4) dazu eingerichtet ist, die Erfassung des Ist-Werts (Sᵢₛₜ) des Fingerprints (FP) und den Vergleich mit dem Sollwert (Sₛₒₗₗ) ausschließlich während des Startvorganges der elektronischen Steuereinheit (1) durchzuführen, und im Falle der Erkennung einer Manipulation eine Fehlerroutine einzuleiten.

17. Kraftfahrzeugscheinwerfer, umfassend ein Fahrzeugmodul (10) nach einem der vorhergehenden Ansprüche.

18. Verfahren zur Verwendung eines Fahrzeugmoduls (10) nach einem der Ansprüche 1 bis 16, wobei während des Herstellungs- und Konfigurationsprozesses des Fahrzeugmoduls (10) eine Grundeinstellungsprozedur durchgeführt wird, in der ein anfänglicher Fingerprint (FP) festgestellt und als Referenzwert in dem Fahrzeugmodul und einem externen Speicher gespeichert wird.
